# EUROPEAN PATENT SPECIFICATION

(11) **EP 4 537 972 B1**
(45) Date of publication and mention of the grant of the patent: **03.06.2026**
(21) Application number: 24203601.0
(22) Date of filing: 30.09.2024
(51) Int. Cl.: B23K 26/354, H01L 21/268

(54) **LASER ANNEALING DEVICE, LASER ANNEALING METHOD, AND STORAGE MEDIUM**
LASERGLÜHVORRICHTUNG, LASERGLÜHVERFAHREN UND SPEICHERMEDIUM
DISPOSITIF DE RECUIT LASER, PROCÉDÉ DE RECUIT LASER ET SUPPORT DE STOCKAGE

(30) Priority: 12.10.2023 JP 2023176660
(43) Date of publication of application: 16.04.2025
(73) Proprietor: Sumitomo Heavy Industries, Ltd., Tokyo 141-6025 (JP)
(72) Inventor: YASUDA, Kazumasa, Kanagawa, 237-8555, (JP)
(74) Representative: Louis Pöhlau Lohrentz

(56) References cited:
- CN-A- 115 621 161
- US-B2- 8 222 126

## Description

### BACKGROUND OF THE INVENTION

### Field of the Invention

The present disclosure relates to a laser annealing device and the like.

### Description of Related Art

Japanese Unexamined Patent Publication No. 2018-67642 discloses a laser annealing device that performs an annealing process by sequentially irradiating an irradiation region on a workpiece such as a semiconductor wafer with a laser pulse. The laser pulse is twodimensionally scanned over the entire irradiation region by an appropriate laser scanning mechanism.

United States Patent No. 8222126 discloses a laser irradiation apparatus used for crystallizing a semiconductor film and a method for manufacturing a Document CN115621161A discloses a semiconductor device. laser annealing device that irradiates an irradiation region having a circular shape on a workpiece with a laser beam for an annealing process.

Such two-dimensional scanning of a laser beam is generally implemented by a combination of first scanning along a first direction and second scanning along a second direction orthogonal to the first direction. For example, in one round of the first scanning, the laser beam is linearly scanned along the first direction between one end and the other end of the irradiation region. In one round of the second scanning, the laser beam is scanned along the second direction, and a position of the subsequent first scanning is shifted.

### SUMMARY OF THE INVENTION

In each round of the first scanning, the laser beam is generally linearly scanned along the first direction from a start position inscribed in a periphery of the irradiation region (for example, a periphery of the semiconductor wafer). In this case, an irradiation position of the laser beam in each round of the first scanning is aligned along the first direction. However, the irradiation positions of the laser beam in different rounds of the first scanning may not be aligned along the second direction. In a case where the irradiation positions of the laser beam are not aligned along the second direction, this may lead to "uneven irradiation" that means low evenness or uniformity of the annealing process over the irradiation region.

The present disclosure has been conceived in view of such circumstances, and an object of the present disclosure is to provide a laser annealing device and the like capable of reducing uneven irradiation in an annealing process.

In order to solve the problem, a laser annealing device according to an aspect of the present disclosure irradiates an irradiation region having a circular shape on a workpiece with a laser beam for an annealing process and includes a laser scanning unit that sequentially irradiates different irradiation positions in the irradiation region with the laser beam by scanning the laser beam, and an irradiation position alignment unit that adjusts the irradiation position in scanning performed by the laser scanning unit such that the different irradiation positions in the irradiation region are aligned along each of a first direction and a second direction intersecting with each other. The laser scanning unit executes first scanning of scanning the laser beam along the first direction and second scanning of scanning the laser beam along the second direction. The irradiation position alignment unit adjusts the irradiation position in at least any of the first scanning or the second scanning such that the different irradiation positions in the irradiation region are aligned along each of the first direction and the second direction. The laser scanning unit executes the first scanning of linearly scanning the laser beam between both ends of the irradiation region along the first direction, and the second scanning of scanning the laser beam along the second direction and shifting a position of the subsequent first scanning. The irradiation position alignment unit performs adjustment such that each irradiation position in later first scanning out of two continuous rounds of the first scanning with the second scanning interposed between the two rounds of the first scanning is aligned with each irradiation position in earlier first scanning along the second direction. The laser annealing device further comprises a start position setting unit that sets the irradiation position inscribed in a periphery of the irradiation region as a start position of an initial round of the first scanning in the irradiation region, and the irradiation position alignment unit sets the irradiation position at an end on a side closer to the start position not to be inscribed in the periphery of the irradiation region in at least any of the second round of the first scanning or later in the irradiation region.

According to the present aspect, since the different irradiation positions in the irradiation region are aligned along the first direction and the second direction, uneven irradiation in the annealing process can be reduced.

Another aspect of the present disclosure is a laser annealing method. The method is a laser annealing method for irradiating an irradiation region having a circular shape on a workpiece with a laser beam for an annealing process and includes sequentially irradiating different irradiation positions in the irradiation region with the laser beam by scanning the laser beam, and adjusting the irradiation position in the scanning such that the different irradiation positions in the irradiation region are aligned along each of a first direction and a second direction intersecting with each other. The scanning comprises first scanning of scanning the laser beam along the first direction and second scanning of scanning the laser beam along the second direction. The irradiation position in at least any of the first scanning or the second scanning is adjusted such that the different irradiation positions in the irradiation region are aligned along each of the first direction and the second direction. The first scanning is executed such that the laser beam is linearly scanned between both ends of the irradiation region along the first direction and the second scanning is executed such that the laser beam is scanned along the second direction to shift a position of the subsequent first scanning. The irradiation position is adjusted such that each irradiation position in later first scanning out of two continuous rounds of the first scanning with the second scanning interposed between the two rounds of the first scanning is aligned with each irradiation position in earlier first scanning along the second direction. The method further comprises setting the irradiation position inscribed in a periphery of the irradiation region as a start position of an initial round of the first scanning in the irradiation region, and the irradiation position at an end on a side closer to the start position is set not to be inscribed in the periphery of the irradiation region in at least any of the second round of the first scanning or later in the irradiation region.

Still another aspect of the present disclosure is a storage medium. The storage medium stores a laser annealing program for irradiating an irradiation region having a circular shape on a workpiece with a laser beam for an annealing process, the laser annealing program causing a computer to execute sequentially irradiating different irradiation positions in the irradiation region with the laser beam by scanning the laser beam, and adjusting the irradiation position in the scanning such that the different irradiation positions in the irradiation region are aligned along each of a first direction and a second direction intersecting with each other. The scanning comprises first scanning of scanning the laser beam along the first direction and second scanning of scanning the laser beam along the second direction. The irradiation position in at least any of the first scanning or the second scanning is adjusted such that the different irradiation positions in the irradiation region are aligned along each of the first direction and the second direction. The first scanning is executed such that the laser beam is linearly scanned between both ends of the irradiation region along the first direction and the second scanning is executed such that the laser beam is scanned along the second direction to shift a position of the subsequent first scanning. The irradiation position is adjusted such that each irradiation position in later first scanning out of two continuous rounds of the first scanning with the second scanning interposed between the two rounds of the first scanning is aligned with each irradiation position in earlier first scanning along the second direction. The laser annealing program further causes the computer to execute setting the irradiation position inscribed in a periphery of the irradiation region as a start position of an initial round of the first scanning in the irradiation region, and the irradiation position at an end on a side closer to the start position is set not to be inscribed in the periphery of the irradiation region in at least any of the second round of the first scanning or later in the irradiation region.

According to the present disclosure, irradiation unevenness in an annealing process can be reduced.

### BRIEF DESCRIPTION OF THE DRAWINGS

Fig. 1 schematically illustrates a configuration of a laser annealing device.
Fig. 2 is a schematic functional block diagram of a laser scanning control unit and the like.
Fig. 3 schematically illustrates an example of first scanning and second scanning of a laser pulse via a laser scanning unit.
Fig. 4 schematically illustrates an example in which irradiation positions in different columns of the first scanning are aligned along an X direction.

### DETAILED DESCRIPTION OF THE INVENTION

Hereinafter, a form for embodying the present disclosure (hereinafter, also referred to as an embodiment) will be described in detail with reference to the drawings. In description and/or the drawings, the same or equivalent components, members, processes, and the like will be designated by the same reference symbols, and description thereof will not be repeated. A scale and a shape of each illustrated part are conveniently set for simplification of description and are not interpreted as limiting unless otherwise specified. The embodiment is an example and does not limit the scope of the present disclosure. All features and combinations thereof presented in the embodiment are not necessarily essential to the present disclosure. For convenience, the embodiment is presented by decomposing the embodiment into components for each function and/or each function group implementing the embodiment. However, one component in the embodiment may actually be implemented by a combination of a plurality of components as separate bodies, or a plurality of components in the embodiment may actually be implemented by one component as an integrated body.

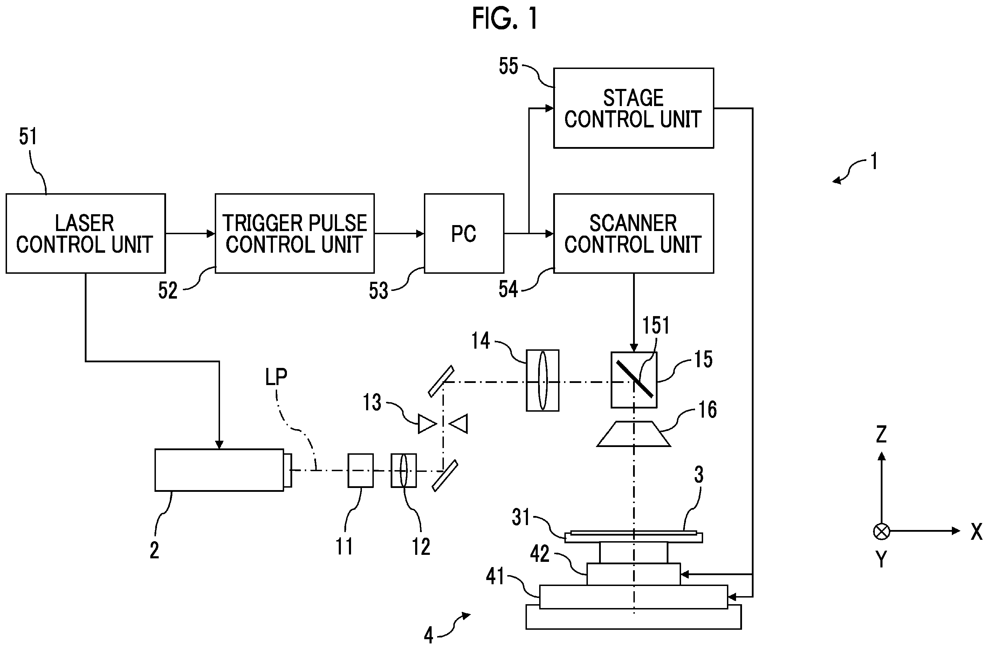

Fig. 1 schematically illustrates a configuration of a laser annealing device 1 according to the embodiment of the present disclosure. The laser annealing device 1 is a device that performs an annealing process (heating process) by irradiating a semiconductor wafer 3 (mounted on a wafer table 31 fixed to a stage device 4, described later) as a workpiece with a laser beam (for example, a laser pulse LP) oscillated by a laser device 2. The laser annealing device 1 in the illustrated example is significantly simplified from the actual one and does not include many components (for example, a component for measuring the laser beam or the semiconductor wafer 3, a component for transporting the semiconductor wafer 3, and a component for stopping irradiation with the laser beam in an emergency) not described in the present embodiment.

The illustrated configuration is merely an example, and the present disclosure may be applied to a laser annealing device having any different configuration. For example, while a control system is configured with a laser control unit 51, a trigger pulse control unit 52, a personal computer (PC) 53, a scanner control unit 54, and a stage control unit 55 in the illustrated example, a control system having any different configuration may be provided as long as the laser annealing device 1 and the laser device 2 can appropriately perform the annealing process on the semiconductor wafer 3. While an energy adjustment mechanism 11, a transmission optical system 12, a mask 13, an irradiation optical system 14, a galvanometer scanner 15, an fθ lens 16, and the like are provided along a path of the laser beam in the illustrated example, any other components may be provided between the laser device 2 and the semiconductor wafer 3 in any disposition as long as the semiconductor wafer 3 is appropriately irradiated with the laser beam from the laser device 2.

Hereinafter, directions related to the configuration and/or an action of the laser annealing device 1 will be described based on a three-dimensional orthogonal coordinate system having each of X, Y, and Z axes orthogonal to each other as a coordinate axis. Hereinafter, for convenience, an X direction and a Y direction will indicate a horizontal direction (that is, an XY plane is a horizontal plane), and a Z direction will indicate a vertical direction. As will be described later, the semiconductor wafer 3 is relatively driven in the XY plane with respect to the laser beam from the laser device 2 under control of the scanner control unit 54 and/or the stage control unit 55.

For example, the semiconductor wafer 3 is driven in the X direction (in this case, the X direction is also referred to as a driving direction) in an integrated manner with a moving table 41 of the stage device 4 that is driven in the X direction by the stage control unit 55. The laser beam from the laser device 2 is scanned in the Y direction (in this case, the Y direction is also referred to as a scanning direction) by the galvanometer scanner 15 that is controlled by the scanner control unit 54. The semiconductor wafer 3 is also driven in the Z direction in an integrated manner with a raising and lowering table 42 of the stage device 4 that is driven in the Z direction by the stage control unit 55 (in this case, the Z direction is also referred to as a raising and lowering direction). The Z direction is also an incidence direction in which the laser beam is incident into the semiconductor wafer 3. Hereinafter, for convenience, the X direction will also be referred to as a longitudinal direction. The Y direction will also be referred to as a lateral direction. The Z direction will also be referred to as a height direction.

For example, the laser device 2 is a pulsed laser device that oscillates the laser pulse LP with a frequency of approximately 20 kHz under control of the laser control unit 51. However, the laser pulse LP oscillated by the laser device 2 may have any frequency. For example, the laser device 2 according to the present embodiment may be configured with a fiber laser device that oscillates the laser pulse LP via an optical fiber.

For example, the laser pulse LP exits in the X direction from the laser device 2. In the laser annealing device 1 in which the laser pulse LP is guided to the semiconductor wafer 3 of an irradiation target (workpiece), the energy adjustment mechanism 11, the transmission optical system 12, the mask 13, the irradiation optical system 14, the galvanometer scanner 15, and the fθ lens 16 are provided in this order along the path of the laser pulse LP (schematically illustrated by a dot-dashed line).

The energy adjustment mechanism 11 adjusts energy or energy density of the laser pulse LP that has exited from the laser device 2, to a value suitable for a desired annealing process.

The transmission optical system 12 is an optical system for transmitting the laser pulse LP. The transmission optical system 12 is configured with any optical element such as a lens, a mirror, a prism, a filter, or a diffraction grating and may be used for not only transmitting the laser pulse LP but also, for example, adjusting a size (diameter) of the laser pulse LP, shaping the laser pulse LP, and adjusting an intensity distribution of the laser pulse LP. Adjusting the size (diameter) of the laser pulse LP and shaping the laser pulse LP may be performed by the mask 13 having a size (diameter) and/or a shape suitable for the desired annealing process. The irradiation optical system 14 is configured with any optical element such as a lens, a mirror, a prism, a filter, or a diffraction grating and adjusts the laser pulse LP to an aspect (for example, a size (diameter), a shape, and an intensity distribution) suitable for irradiating the semiconductor wafer 3.

The galvanometer scanner 15 is a laser scanning unit that scans the laser pulse LP adjusted by the irradiation optical system 14 or the like along the Y direction. The galvanometer scanner 15 includes a galvanometer mirror 151 as a drivable optical element that reflects the incident laser pulse LP to a desired scanning position in the Y direction, and a motor (not illustrated) that drives the galvanometer mirror 151 to a desired posture or a desired angle. By adjusting the posture or the angle of the galvanometer mirror 151 via the motor, the laser pulse LP incident into the galvanometer mirror 151 is reflected to the desired position in the Y direction.

The laser scanning unit that directs the incident laser pulse LP to the desired scanning position in the Y direction is not limited to the galvanometer scanner 15 and may be configured with an optical element such as a polygon mirror scanner including a rotationally drivable polygon mirror (optical element) or a drivable micro electro mechanical systems (MEMS) mirror. The scanning direction of the laser pulse LP achieved by the laser scanning unit such as the galvanometer scanner 15 is also not limited to the Y direction and may be a direction such as the X direction intersecting with the Y direction or two directions of the X direction and the Y direction. Like the latter, in a case where the laser scanning unit such as the galvanometer scanner 15 can scan the laser pulse LP over the XY plane, that is, a surface of the semiconductor wafer 3, the stage device 4 (moving table 41) that drives the semiconductor wafer 3 and the wafer table 31 in the X direction or the like may not be provided. In this case, a laser scanning unit in two directions of the X direction and the Y direction is configured with the galvanometer scanner 15 or the like.

The fθ lens 16 condenses the laser pulse LP scanned in the Y direction by the galvanometer scanner 15 on the semiconductor wafer 3 of an annealing target. The laser pulse LP from the fθ lens 16 is incident into the semiconductor wafer 3 in the Z direction. The laser pulse LP condensed on the semiconductor wafer 3 by the fθ lens 16 is moved on the surface of the semiconductor wafer 3 in the Y direction by scanning in the Y direction by the galvanometer scanner 15. The size of the laser pulse LP condensed on the semiconductor wafer 3 can be designed to be any size but is, for example, preferably between 0.10 mm square and 0.15 mm square and more preferably between 0.12 mm square and 0.13 mm square. A scanning speed of the laser pulse LP in the Y direction on the surface of the semiconductor wafer 3 (and/or a driving speed of the semiconductor wafer 3 in the X direction achieved by the stage device 4 (moving table 41)) can also be designed to be any speed but is, for example, preferably between 10 cm/s and 500 cm/s and more preferably between 100 cm/s and 300 cm/s.

The moving table 41 of the stage device 4 is a driving device that relatively drives the semiconductor wafer 3 and the wafer table 31 along the X direction with respect to the laser pulse LP. The laser pulse LP is relatively moved on the surface of the semiconductor wafer 3 in the X direction by the moving table 41.

As described above, by combining scanning of the laser pulse LP in the Y direction by the galvanometer scanner 15 as a laser scanning unit in the Y direction with driving of the semiconductor wafer 3 in the X direction by the moving table 41 as a laser scanning unit in the X direction, the laser pulse LP can be scanned over the XY plane, that is, the surface of the semiconductor wafer 3. The driving direction of the semiconductor wafer 3 achieved by the moving table 41 is not limited to the X direction and may be a direction such as the Y direction intersecting with the X direction or two directions of the X direction and the Y direction. Like the latter, in a case where the moving table 41 can relatively drive the semiconductor wafer 3 over the XY plane with respect to the laser pulse LP, the galvanometer scanner 15 that scans the laser pulse LP in the Y direction or the like may not be provided. In this case, a laser scanning unit in two directions of the X direction and the Y direction is configured with the moving table 41.

The laser annealing device 1 and the laser device 2 as described above are controlled by the control system including the laser control unit 51, the trigger pulse control unit 52, the personal computer 53, the scanner control unit 54, and the stage control unit 55.

The laser control unit 51 controls the laser pulse LP oscillated by the laser device 2 based on various control parameters. Examples of the control parameters include the energy of the laser pulse LP, the energy density of the laser pulse LP, a repetition frequency of the laser pulse LP, a duration (pulse width) of the laser pulse LP, peak intensity of the laser pulse LP, a profile (for example, the intensity distribution) of the laser pulse LP, a delay time (time difference) in irradiating the same location with the laser pulse LP via a plurality of laser devices 2 (not illustrated), and an overlap ratio (a ratio of an overlap between irradiation marks) between adjacent rows (or adjacent columns) in a case where the laser pulse LP is scanned in a reciprocating manner.

The trigger pulse control unit 52 generates a trigger pulse that is synchronized with the laser pulse LP oscillated by the laser device 2, based on a synchronization signal provided from the laser control unit 51. For example, a frequency of the trigger pulse generated by the trigger pulse control unit 52 is 1/N (N is any natural number) times or N times the repetition frequency or the oscillation frequency of the laser pulse LP.

The scanner control unit 54 controls the galvanometer scanner 15 (scanner control) based on the trigger pulse that is processed by the personal computer 53, as necessary. Similarly, the stage control unit 55 controls the moving table 41 (stage control) of the stage device 4 based on the trigger pulse that is processed by the personal computer 53, as necessary. Based on the trigger pulse synchronized with the laser pulse LP, the scanner control unit 54 can appropriately execute scanning of the laser pulse LP in the Y direction by the galvanometer scanner 15, and the stage control unit 55 can appropriately execute driving of the semiconductor wafer 3 in the X direction by the moving table 41. The personal computer 53 may be used for adjustment in the scanner control unit 54 and/or the stage control unit 55 (hereinafter, collectively referred to as a laser scanning control unit 56) described below.

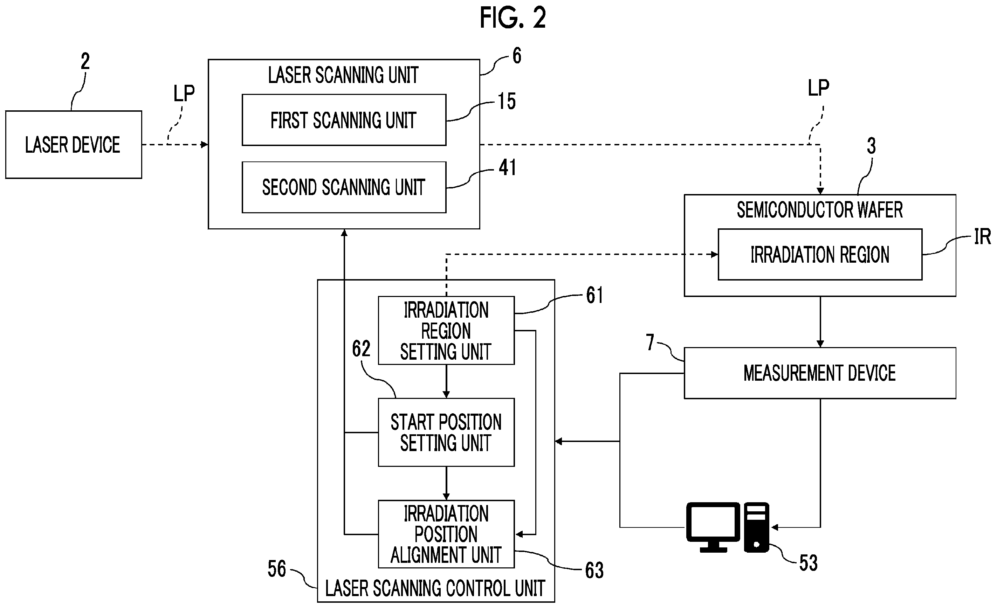

Fig. 2 is a schematic functional block diagram of the laser scanning control unit 56 and the like according to the present embodiment. The laser scanning control unit 56 includes an irradiation region setting unit 61, a start position setting unit 62, and an irradiation position alignment unit 63. A part of these functional blocks may be omitted as long as the laser scanning control unit 56 can implement at least a part of actions and/or effects described below. These functional blocks may be implemented by cooperation between hardware resources such as a central processing unit, a memory, an input device, and an output device of a computer and a peripheral device connected to the computer and software executed using the hardware resources. Regardless of a type or an installation location of the computer, each of the functional blocks may be implemented by a hardware resource of a single computer or be implemented by combining hardware resources distributed between a plurality of computers.

The laser scanning control unit 56 controls first scanning of the laser pulse LP along the Y direction as a first direction and second scanning of the laser pulse LP along the X direction as a second direction performed by the laser scanning unit 6. As in the example in Fig. 1, in a case where the galvanometer scanner 15 functions as a first scanning unit that executes the first scanning of the laser pulse LP along the Y direction, the scanner control unit 54 that is a part of the laser scanning control unit 56 functions as a first scanning control unit that controls a first scanning unit 15. In a case where the moving table 41 functions as a second scanning unit that executes the second scanning of the laser pulse LP along the X direction (driving of the semiconductor wafer 3 along the X direction), the stage control unit 55 that is a part of the laser scanning control unit 56 functions as a second scanning control unit that controls a second scanning unit 41. The following description will follow this example unless otherwise specified.

As described above, in a case where the galvanometer scanner 15 functions as the first scanning unit and the second scanning unit that execute the first scanning and the second scanning of the laser pulse LP along both of the Y direction and the X direction, the laser scanning control unit 56 may be configured with only the scanner control unit 54 that substantially controls the galvanometer scanner 15. Similarly, in a case where the moving table 41 functions as the first scanning unit and the second scanning unit that execute the first scanning and the second scanning of the laser pulse LP along both of the Y direction and the X direction, the laser scanning control unit 56 may be configured with only the stage control unit 55 that substantially controls the moving table 41.

The irradiation region setting unit 61 sets one or a plurality of irradiation regions IR on the semiconductor wafer 3 as the workpiece. The irradiation region IR means a region on the semiconductor wafer 3 irradiated with the laser pulse LP through a series or one round of XY scanning (plane scanning) performed by the galvanometer scanner 15 and the moving table 41. As long as there is no issue in terms of performance and the like of the laser device 2 and the laser scanning unit 6, the irradiation region setting unit 61 preferably sets the entire surface (the entirety of the surface) of the semiconductor wafer 3 to be processed as the irradiation region IR, as schematically illustrated in Fig. 2. Meanwhile, in a case where the entire surface of the semiconductor wafer 3 cannot be covered in one round of the XY scanning, the irradiation region setting unit 61 may divide a surface of the semiconductor wafer 3 to be processed into a plurality of irradiation regions IR.

For the irradiation region IR on the semiconductor wafer 3 as described above, the laser scanning unit 6 sequentially irradiates different irradiation positions in the irradiation region IR while scanning the laser pulse LP in the X and Y directions under control of the laser scanning control unit 56. As described above, in the example of the present embodiment, the galvanometer scanner 15 as the first scanning unit executes the first scanning with of the laser pulse LP along the Y direction, and the moving table 41 as the second scanning unit executes the second scanning of the laser pulse LP along the X direction.

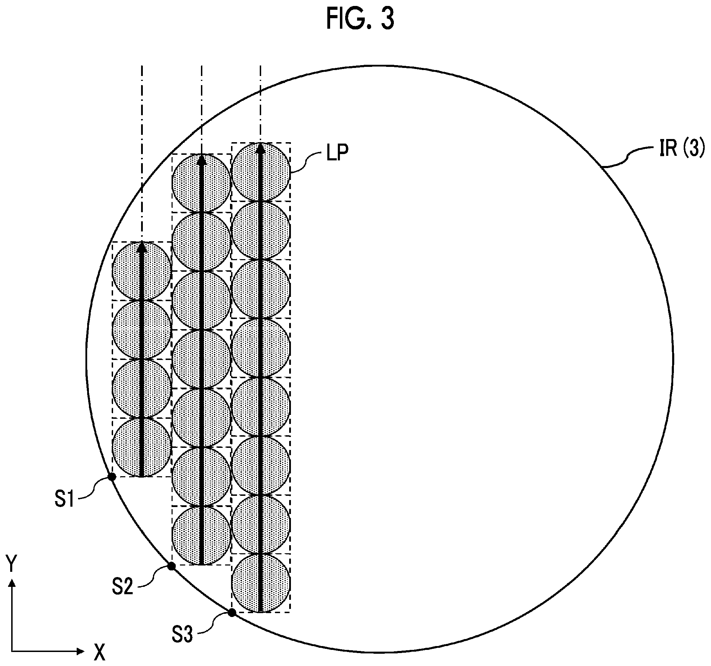

Fig. 3 schematically illustrates an example of the first scanning and the second scanning of the laser pulse LP performed by the laser scanning unit 6. Multiple circles in the drawing schematically illustrate regions (hereinafter, referred to as irradiation marks for convenience) in which the annealing process is performed by performing continuous irradiation with the laser pulse LP while sequentially changing (that is, while scanning) the irradiation position in the irradiation region IR set by the irradiation region setting unit 61. In this example, as schematically illustrated by an arrow in an up-down direction, the galvanometer scanner 15 as the first scanning unit executes first scanning of linearly scanning the laser pulse LP along the Y direction between both ends (upper and lower ends in Fig. 3) of the irradiation region IR. The moving table 41 as the second scanning unit executes the second scanning of scanning the laser pulse LP along the X direction (the second direction that intersects with or is orthogonal to the Y direction as the first direction) and shifting a position of the subsequent first scanning.

In the illustrated example, a unit scanning amount (a distance between two adjacent or continuous irradiation positions of the laser pulses LP) in each of the first scanning and the second scanning is typically set to a length of one irradiation mark. Thus, the irradiation marks are substantially tangent to each other without overlapping. However, in the present disclosure, each of the unit scanning amount of the first scanning (the distance in the Y direction) and the unit scanning amount of the second scanning (the distance in the X direction) may be any amount. For example, in a case where the unit scanning amount of the first scanning is smaller than a size of the irradiation mark, two irradiation marks adjacent to each other in the Y direction overlap with each other. Similarly, in a case where the unit scanning amount of the second scanning is smaller than the size of the irradiation mark, two irradiation marks adjacent to each other in the X direction overlap with each other.

In the illustrated example, the first scanning of the laser pulse LP in the Y direction is continuously executed while the position in the X direction is shifted by the second scanning. Specifically, the first scanning from a -Y side (a lower side in Fig. 3) to a +Y side (an upper side in Fig. 3) is sequentially executed over a plurality of rounds from a -X side (a left side in Fig. 3) to a +X side (a right side in Fig. 3) of the irradiation region IR having a circular shape (second scanning). In Fig. 3, irradiation marks formed by three rounds of the first scanning from the initial round are illustrated. Columns of the irradiation marks formed by each round of the first scanning in the Y direction are referred to as a first column, a second column, and a third column in order from the left side in Fig. 3.

A start position or a lower end position of the first scanning in each column is set by the start position setting unit 62. In the example in Fig. 3, the start position setting unit 62 sets the irradiation position inscribed in a periphery of the irradiation region IR at each X position of the first column, the second column, and the third column as a start position S1 of the first scanning in the first column, a start position S2 of the first scanning in the second column, and a start position S3 of the first scanning in the third column. Consequently, the irradiation position substantially closest to the periphery of the irradiation region IR is set as the start position or the lower end position of the first scanning in each column. Thus, efficiency of use for the annealing process of the irradiation region IR can be increased.

Meanwhile, since the start position or the lower end position of the first scanning in each column is set to a different position inscribed in the periphery of the irradiation region IR for each column, an issue arises in that the irradiation mark of each column (the first column to the third column) is not aligned in the X direction (second direction), as illustrated. In a case where the irradiation positions of the laser pulse LP are not aligned along the X direction, this may lead to "uneven irradiation" that means low evenness or uniformity of the annealing process over the irradiation region IR.

In the present embodiment, the irradiation position alignment unit 63 in Fig. 2 is provided in order to reduce such uneven irradiation in the annealing process. The irradiation position alignment unit 63 adjusts the irradiation position in at least any of the first scanning or the second scanning such that different irradiation positions or irradiation marks in the irradiation region IR are aligned along the first direction (Y direction) and the second direction (X direction). In the illustrated example, as described above, since the laser pulse LP is scanned along the Y direction in each round of the first scanning by the galvanometer scanner 15, the irradiation positions or the irradiation marks are naturally aligned (independently of the irradiation position alignment unit 63) in the Y direction in each column of the first scanning.

Therefore, in the illustrated example, the irradiation position alignment unit 63 adjusts the irradiation position in the first scanning such that the irradiation positions or the irradiation marks of the first scanning in different columns (for example, the first column to the third column illustrated) are aligned along the second direction (X direction). For example, the irradiation position alignment unit 63 performs adjustment such that each irradiation position in the later first scanning out of two continuous rounds of the first scanning with the second scanning interposed therebetween is aligned with each irradiation position in the earlier first scanning along the second direction. Specifically, the irradiation position alignment unit 63 performs adjustment such that each irradiation position in the first scanning in the later second column out of two continuous rounds of the first scanning in the first column and the second column is aligned with each irradiation position in the first scanning in the earlier first column along the second direction. Similarly, the irradiation position alignment unit 63 performs adjustment such that each irradiation position in the first scanning in the later third column out of two continuous rounds of the first scanning in the second column and the third column is aligned with each irradiation position in the first scanning in the earlier second column along the second direction.

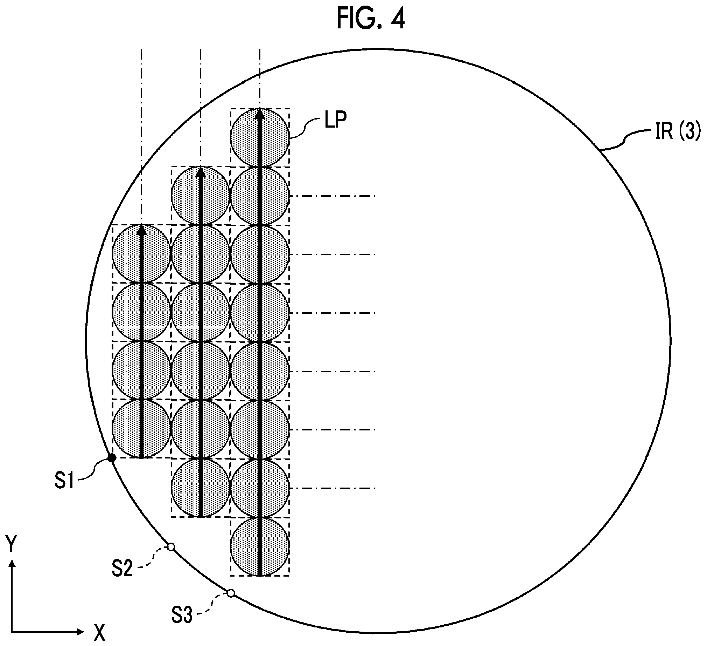

As a result of the alignment of the irradiation positions performed by the irradiation position alignment unit 63 as described above, the irradiation positions or the irradiation marks of the first scanning in different columns are aligned along the X direction, as schematically illustrated in Fig. 4. Accordingly, different irradiation positions or irradiation marks are disposed to be aligned in a lattice form along the first direction (Y direction) and the second direction (X direction) over the entire irradiation region IR. According to the present embodiment, since different irradiation positions in the irradiation region IR are aligned along the first direction (Y direction) and the second direction (X direction), the uneven irradiation in the annealing process can be reduced.

In the first scanning in the first column that is the initial round of the first scanning in the irradiation region IR, the same start position or lower end position as the example in Fig. 3 is set by the start position setting unit 62. That is, the start position setting unit 62 sets the irradiation position inscribed in the periphery of the irradiation region IR as the start position S1 of the first scanning in the first column. Considering an alignment process of the irradiation positions performed by the irradiation position alignment unit 63, the start position S1 is preferably set by the start position setting unit 62 such that a total number of rounds of irradiation with the laser pulse LP (a total number of beams) in the irradiation region IR is maximized.

The start position S1 in Fig. 4 is a lower left corner of the laser pulse LP or the irradiation mark. Thus, a position shifted from the start position S1 by half of a dimension of the laser pulse LP or the irradiation mark (for example, a radius of the laser pulse LP or the irradiation mark having a circular cross section) in each of the X direction and the Y direction (that is, a center position of the laser pulse LP or the irradiation mark) is the actual irradiation start position of the laser pulse LP.

As schematically illustrated in Fig. 4, the irradiation position alignment unit 63 sets the irradiation position at a lower end on a side closer to the start position S1 not to be inscribed in the periphery of the irradiation region IR in at least any of the second round of the first scanning or later in the irradiation region IR. Specifically, in the first scanning in the second column and the third column, the irradiation position alignment unit 63 sets the irradiation start position at the lower end on the side closer to the start position S1 to a position different from the positions S2 and S3 (the irradiation start positions in Fig. 3) inscribed in the periphery of the irradiation region IR. As described above, in the first scanning in the second column or later, the irradiation start position or an end position is set in accordance with disposition of the irradiation position or the irradiation mark in the first scanning in the earlier column, instead of the position (S2 or S3) inscribed in the periphery of the irradiation region IR. Accordingly, aligned disposition of the irradiation positions or the irradiation marks in a lattice form can be implemented over the entire irradiation region IR.

The adjustment of the irradiation positions performed by the irradiation position alignment unit 63 as described above may be manually performed through the personal computer 53 that can be operated by a user such as a manager of the laser annealing device 1. Specifically, the irradiation position alignment unit 63 adjusts the irradiation position in at least any of the first scanning (Y scanning) or the second scanning (X scanning) based on irradiation position adjustment information provided from the personal computer 53 in response to an operation of the user.

In manually adjusting the irradiation position, a measurement device 7 that measures the disposition of the irradiation marks and various characteristics of the semiconductor wafer 3 after the actual annealing process is performed with the laser pulse LP based on the irradiation position before the adjustment and/or the irradiation position after the adjustment may be used. A measurement result of the measurement device 7 is provided to the personal computer 53 and is presented or displayed to the user through a monitor or the like of the personal computer 53. Accordingly, for example, the user can check whether or not the irradiation position set by the user implements desired irradiation mark disposition and characteristics on the semiconductor wafer 3 in substantially real time. In a case where the irradiation position does not implement the desired irradiation mark disposition and characteristics on the semiconductor wafer 3, the user can appropriately update the irradiation position by operating the personal computer 53.

Instead of the manual adjustment performed by the user via the personal computer 53 as described above, the irradiation position alignment unit 63 may autonomously (or automatically) set an adjustment value of the irradiation position based on the measurement result from the measurement device 7. The irradiation position alignment unit 63 autonomously sets an appropriate irradiation position such that the desired irradiation mark disposition and characteristics (measured by the measurement device 7) on the semiconductor wafer 3 are implemented.

The characteristics of the semiconductor wafer 3 (after the annealing process) measured by the measurement device 7 may be any characteristics. Examples of the characteristics include sheet resistance at each irradiation position of the semiconductor wafer 3. The irradiation position alignment unit 63 that automatically adjusts the irradiation position can set the optimal irradiation position in each part of the irradiation region IR with comprehensive reference to the measurement result.

The irradiation position alignment unit 63 may autonomously (or automatically) set the adjustment value of the irradiation position based on various types of setting information or control parameters such as the irradiation region IR set by the irradiation region setting unit 61, the start position S1 set by the start position setting unit 62, the unit scanning amount of the laser pulse LP (particularly, in the X direction), the size of the laser pulse LP, the profile of the laser pulse LP, and the overlap ratio of the laser pulse LP, without using the measurement result from the measurement device 7.

The present disclosure has been described above based on the embodiment. Those skilled in the art will perceive that various modification examples can be made to a combination of each component and each process in the illustrated embodiment, provided such modification examples fall within the scope of the claims.

While scanning of the laser pulse LP in the irradiation region IR is implemented by a combination of the X scanning and the Y scanning that are both linear scanning (referred to as raster scan) in the above embodiment, the scanning may be implemented in any other aspects. For example, the laser pulse LP may be spirally scanned mainly along a circumferential direction of the circular irradiation region IR. Even in this case, the irradiation position alignment unit 63 sets an appropriate irradiation position in each part of the irradiation region IR such that the aligned disposition of the irradiation positions or the irradiation marks in a lattice form is implemented over the entire irradiation region IR.

A configuration, an action, and a function of each device or each method described in the embodiment can be implemented by hardware resources or software resources or by cooperation between hardware resources and software resources. For example, a processor, a ROM, a RAM, and various integrated circuits can be used as the hardware resources. For example, programs such as an operating system and an application can be used as the software resources.

### Brief Description of the Reference Symbols

- 1: LASER ANNEALING DEVICE
- 2: LASER DEVICE
- 3: SEMICONDUCTOR WAFER
- 4: STAGE DEVICE
- 6: LASER SCANNING UNIT
- 7: MEASUREMENT DEVICE
- 15: GALVANOMETER SCANNER
- 41: MOVING TABLE
- 53: PERSONAL COMPUTER
- 54: SCANNER CONTROL UNIT
- 55: STAGE CONTROL UNIT
- 56: LASER SCANNING CONTROL UNIT
- 61: IRRADIATION REGION SETTING UNIT
- 62: START POSITION SETTING UNIT
- 63: IRRADIATION POSITION ALIGNMENT UNIT
- LP: LASER PULSE

## Claims

1. A laser annealing device (1) that irradiates an irradiation region (IR) having a circular shape on a workpiece with a laser beam for an annealing process, the laser annealing device (1) comprising:
a laser scanning unit (6) that sequentially irradiates different irradiation positions in the irradiation region (IR) with the laser beam by scanning the laser beam; and
an irradiation position alignment unit (63) that adjusts the irradiation position in scanning performed by the laser scanning unit (6) such that the different irradiation positions in the irradiation region (IR) are aligned along each of a first direction and a second direction intersecting with each other,
wherein
the laser scanning unit (6) executes first scanning of scanning the laser beam along the first direction and second scanning of scanning the laser beam along the second direction,
the irradiation position alignment unit (63) adjusts the irradiation position in at least any of the first scanning or the second scanning such that the different irradiation positions in the irradiation region (IR) are aligned along each of the first direction and the second direction,
the laser scanning unit (6) executes the first scanning of linearly scanning the laser beam between both ends of the irradiation region (IR) along the first direction, and the second scanning of scanning the laser beam along the second direction and shifting a position of the subsequent first scanning,
the irradiation position alignment unit (63) performs adjustment such that each irradiation position in later first scanning out of two continuous rounds of the first scanning with the second scanning interposed between the two rounds of the first scanning is aligned with each irradiation position in earlier first scanning along the second direction, **characterized in that**
the laser annealing device (1) further comprises a start position setting unit (62) that sets the irradiation position inscribed in a periphery of the irradiation region (IR) as a start position (S1) of an initial round of the first scanning in the irradiation region (IR), and
the irradiation position alignment unit (63) sets the irradiation position at an end on a side closer to the start position (S1) not to be inscribed in the periphery of the irradiation region (IR) in at least any of the second round of the first scanning or later in the irradiation region (IR).

2. A laser annealing method for irradiating an irradiation region (IR) having a circular shape on a workpiece with a laser beam for an annealing process, the method comprising:
sequentially irradiating different irradiation positions in the irradiation region (IR) with the laser beam by scanning the laser beam; and
adjusting the irradiation position in the scanning such that the different irradiation positions in the irradiation region (IR) are aligned along each of a first direction and a second direction intersecting with each other,
wherein
the scanning comprises first scanning of scanning the laser beam along the first direction and second scanning of scanning the laser beam along the second direction,
the irradiation position in at least any of the first scanning or the second scanning is adjusted such that the different irradiation positions in the irradiation region (IR) are aligned along each of the first direction and the second direction,
the first scanning is executed such that the laser beam is linearly scanned between both ends of the irradiation region (IR) along the first direction and the second scanning is executed such that the laser beam is scanned along the second direction to shift a position of the subsequent first scanning,
the irradiation position is adjusted such that each irradiation position in later first scanning out of two continuous rounds of the first scanning with the second scanning interposed between the two rounds of the first scanning is aligned with each irradiation position in earlier first scanning along the second direction,
**characterized in that** the method further comprises setting the irradiation position inscribed in a periphery of the irradiation region (IR) as a start position (S1) of an initial round of the first scanning in the irradiation region (IR), and
the irradiation position at an end on a side closer to the start position (S1) is set not to be inscribed in the periphery of the irradiation region (IR) in at least any of the second round of the first scanning or later in the irradiation region (IR).

3. A storage medium storing a laser annealing program for irradiating an irradiation region (IR) having a circular shape on a workpiece with a laser beam for an annealing process, the laser annealing program causing a computer to execute:
sequentially irradiating different irradiation positions in the irradiation region (IR) with the laser beam by scanning the laser beam; and
adjusting the irradiation position in the scanning such that the different irradiation positions in the irradiation region (IR) are aligned along each of a first direction and a second direction intersecting with each other,
wherein
the scanning comprises first scanning of scanning the laser beam along the first direction and second scanning of scanning the laser beam along the second direction,
the irradiation position in at least any of the first scanning or the second scanning is adjusted such that the different irradiation positions in the irradiation region (IR) are aligned along each of the first direction and the second direction,
the first scanning is executed such that the laser beam is linearly scanned between both ends of the irradiation region (IR) along the first direction and the second scanning is executed such that the laser beam is scanned along the second direction to shift a position of the subsequent first scanning,
the irradiation position is adjusted such that each irradiation position in later first scanning out of two continuous rounds of the first scanning with the second scanning interposed between the two rounds of the first scanning is aligned with each irradiation position in earlier first scanning along the second direction,
**characterized in that** the laser annealing program further causes the computer to execute setting the irradiation position inscribed in a periphery of the irradiation region (IR) as a start position (S1) of an initial round of the first scanning in the irradiation region (IR), and
the irradiation position at an end on a side closer to the start position (S1) is set not to be inscribed in the periphery of the irradiation region (IR) in at least any of the second round of the first scanning or later in the irradiation region (IR).

## Patentansprüche

1. Laserglühvorrichtung (1), die einen Bestrahlungsbereich (IR) mit einer kreisförmigen Form auf einem Werkstück mit einem Laserstrahl für einen Glühprozess bestrahlt, wobei die Laserglühvorrichtung (1) umfasst:
eine Laserscaneinheit (6), die nacheinander verschiedene Bestrahlungspositionen im Bestrahlungsbereich (IR) mit dem Laserstrahl durch Scannen des Laserstrahls bestrahlt; und
eine Bestrahlungspositionsausrichtungseinheit (63), die die Bestrahlungsposition bei Scannen, das von der Laserscaneinheit (6) ausgeführt wird, so anpasst, dass die verschiedenen Bestrahlungspositionen in dem Bestrahlungsbereich (IR) entlang jeweils einer ersten Richtung und einer zweiten Richtung, die einander schneiden, ausgerichtet sind,
wobei
die Laserscaneinheit (6) erstes Scannen, bei dem der Laserstrahl entlang der ersten Richtung gescannt wird, und zweites Scannen, bei dem der Laserstrahl entlang der zweiten Richtung gescannt wird, ausführt,
die Bestrahlungspositionsausrichtungseinheit (63) die Bestrahlungsposition bei mindestens einem von dem ersten Scannen oder dem zweiten Scannen so anpasst, dass die verschiedenen Bestrahlungspositionen in dem Bestrahlungsbereich (IR) entlang jeweils der ersten Richtung und der zweiten Richtung ausgerichtet sind,
die Laserscaneinheit (6) das erste Scannen, bei dem der Laserstrahl linear zwischen beiden Enden des Bestrahlungsbereichs (IR) entlang der ersten Richtung gescannt wird, sowie das zweite Scannen, bei dem der Laserstrahl entlang der zweiten Richtung gescannt und eine Position des nachfolgenden ersten Scannens verschoben wird, ausführt,
die Bestrahlungspositionsausrichtungseinheit (63) Anpassung so durchführt, dass jede Bestrahlungsposition bei späterem ersten Scannen aus zwei aufeinanderfolgenden Durchgängen des ersten Scannens, wobei das zweite Scannen zwischen den beiden Durchgängen des ersten Scannens eingeschoben ist, mit jeder Bestrahlungsposition bei früherem ersten Scannen entlang der zweiten Richtung ausgerichtet ist,
**dadurch gekennzeichnet, dass**
die Laserglühvorrichtung (1) ferner eine Startpositionseinstellungseinheit (62) umfasst, die die Bestrahlungsposition, die in einem Umfang des Bestrahlungsbereichs (IR) eingeschrieben ist, als eine Startposition (S1) eines ersten Durchgangs des ersten Scannens in dem Bestrahlungsbereich (IR) einstellt, und
die Bestrahlungspositionsausrichtungseinheit (63) die Bestrahlungsposition an einem Ende auf einer Seite, die näher an der Startposition (S1) liegt, so einstellt, dass sie nicht in dem Umfang des Bestrahlungsbereichs (IR) eingeschrieben ist, in mindestens einem von dem zweiten Durchgang des ersten Scannens oder später in dem Bestrahlungsbereich (IR).

2. Laserglühverfahren zum Bestrahlen eines Bestrahlungsbereichs (IR) mit einer kreisförmigen Form auf einem Werkstück mit einem Laserstrahl für einen Glühprozess, wobei das Verfahren umfasst:
aufeinanderfolgendes Bestrahlen verschiedener Bestrahlungspositionen in dem Bestrahlungsbereich (IR) mit dem Laserstrahl durch Scannen des Laserstrahls; und
Anpassen der Bestrahlungsposition bei dem Scannen so, dass die verschiedenen Bestrahlungspositionen in dem Bestrahlungsbereich (IR) entlang jeweils einer ersten Richtung und einer zweiten Richtung, die einander schneiden, ausgerichtet sind,
wobei
das Scannen erstes Scannen, bei dem der Laserstrahl entlang der ersten Richtung gescannt wird, und zweites Scannen, bei dem der Laserstrahl entlang der zweiten Richtung gescannt wird, umfasst,
die Bestrahlungsposition bei zumindest einem von dem ersten Scannen oder dem zweiten Scannen so angepasst wird, dass die verschiedenen Bestrahlungspositionen in dem Bestrahlungsbereich (IR) entlang jeder von der ersten Richtung und der zweiten Richtung ausgerichtet sind,
das erste Scannen so ausgeführt wird, dass der Laserstrahl linear zwischen beiden Enden des Bestrahlungsbereichs (IR) entlang der ersten Richtung gescannt wird, und das zweite Scannen so ausgeführt wird, dass der Laserstrahl entlang der zweiten Richtung gescannt wird, um eine Position des nachfolgenden ersten Scannens zu verschieben,
die Bestrahlungsposition so angepasst wird, dass jede Bestrahlungsposition bei späterem ersten Scannen aus zwei aufeinanderfolgenden Durchgängen des ersten Scannens, wobei das zweite Scannen zwischen den zwei Durchgängen des ersten Scannens eingeschoben ist, mit jeder Bestrahlungsposition bei früherem ersten Scannen entlang der zweiten Richtung, ausgerichtet ist,
**dadurch gekennzeichnet, dass**
das Verfahren ferner Einstellen der Bestrahlungsposition, die in einem Umfang des Bestrahlungsbereichs (IR) eingeschrieben ist, als eine Startposition (S1) eines ersten Durchgangs des ersten Scannens in dem Bestrahlungsbereich (IR), umfasst und
die Bestrahlungsposition an einem Ende einer Seite, die näher an der Startposition (S1) ist, so eingestellt ist, dass sie in den Umfang des Bestrahlungsbereichs (IR) nicht eingeschrieben ist bei mindestens einem von dem zweiten Durchgang des ersten Scannens oder später in dem Bestrahlungsbereich (IR).

3. Speichermedium, das ein Laser-Glühprogramm speichert, um einen Bestrahlungsbereich (IR) mit einer kreisförmigen Form auf einem Werkstück mit einem Laserstrahl für einen Glühprozess zu bestrahlen, wobei das Laser-Glühprogramm einen Computer veranlasst, auszuführen:
sequenzielles Bestrahlen verschiedener Bestrahlungspositionen in dem Bestrahlungsbereich (IR) mit dem Laserstrahl durch Scannen des Laserstrahls; und
Anpassen der Bestrahlungsposition bei dem Scannen so, dass die verschiedenen Bestrahlungspositionen in dem Bestrahlungsbereich (IR) entlang jeder von einer ersten Richtung und einer zweiten Richtung, die einander schneiden, ausgerichtet sind,
wobei
das Scannen erstes Scannen des Laserstrahls entlang der ersten Richtung und zweites Scannen des Laserstrahls entlang der zweiten Richtung umfasst,
die Bestrahlungsposition bei zumindest einem von dem ersten Scannen oder dem zweiten Scannen so angepasst wird, dass die verschiedenen Bestrahlungspositionen in dem Bestrahlungsbereich (IR) entlang jeder der ersten Richtung und der zweiten Richtung ausgerichtet sind,
das erste Scannen so ausgeführt wird, dass der Laserstrahl linear zwischen beiden Enden des Bestrahlungsbereichs (IR) entlang der ersten Richtung gescannt wird, und das zweite Scannen so ausgeführt wird, dass der Laserstrahl entlang der zweiten Richtung gescannt wird, um eine Position des nachfolgenden ersten Scannens zu verschieben,
die Bestrahlungsposition so angepasst wird, dass jede Bestrahlungsposition bei späterem ersten Scannen aus zwei aufeinanderfolgenden Durchgängen des ersten Scannens, wobei das zweite Scannen zwischen den beiden Durchgängen des ersten Scannens eingeschoben ist, mit jeder Bestrahlungsposition bei früherem ersten Scannen entlang der zweiten Richtung ausgerichtet ist,
**dadurch gekennzeichnet, dass**
das Laser-Glühprogramm den Computer ferner veranlasst, Einstellen der Bestrahlungsposition, die in einem Umfang des Bestrahlungsbereichs (IR) eingeschrieben ist, als eine Startposition (S1) eines anfänglichen Durchgangs des ersten Scannens in dem Bestrahlungsbereich (IR)auszuführen, und
die Bestrahlungsposition an einem Ende auf der Seite, die näher an der Startposition (S1) ist, so einzustellen, dass sie in den Umfang des Bestrahlungsbereichs (IR) nicht eingeschrieben ist bei zumindest einem von dem zweiten Durchgang des ersten Scannens oder später in dem Bestrahlungsbereich (IR).

## Revendications

1. Un dispositif de recuit laser (1) qui irradie une région d'irradiation (IR) ayant une forme circulaire sur une pièce à usiner avec un faisceau laser pour un processus de recuit, le dispositif de recuit laser (1) comprenant :
une unité de balayage laser (6) qui irradie séquentiellement différentes positions d'irradiation dans la région d'irradiation (IR) avec le faisceau laser en balayant le faisceau laser ; et
une unité d'alignement de position d'irradiation (63) qui ajuste la position d'irradiation dans le balayage effectué par l'unité de balayage laser (6) de sorte que les différentes positions d'irradiation dans la région d'irradiation (IR) sont alignées le long d'une première direction et d'une deuxième direction qui se croisent mutuellement,
dans lequel
l'unité de balayage laser (6) exécute un premier balayage consistant à balayer le faisceau laser le long de la première direction et un deuxième balayage consistant à balayer le faisceau laser le long de la deuxième direction,
l'unité d'alignement de position d'irradiation (63) ajuste la position d'irradiation dans au moins l'un quelconque du premier balayage ou du deuxième balayage de sorte que les différentes positions d'irradiation dans la région d'irradiation (IR) sont alignées le long de chacune de la première direction et de la deuxième direction,
l'unité de balayage laser (6) exécute le premier balayage consistant à balayer linéairement le faisceau laser entre les deux extrémités de la région d'irradiation (IR) le long de la première direction, et le deuxième balayage consistant à balayer le faisceau laser le long de la deuxième direction et à décaler une position du premier balayage subséquent,
l'unité d'alignement de position d'irradiation (63) effectue un ajustement de sorte que chaque position d'irradiation dans le premier balayage ultérieur parmi deux cycles continus du premier balayage, où le deuxième balayage est intercalé entre les deux cycles du premier balayage, est alignée avec chaque position d'irradiation dans le premier balayage antérieur le long de la deuxième direction, **caractérisé en ce que**
le dispositif de recuit laser (1) comprend en outre une unité de définition de position de départ (62) qui définit la position d'irradiation inscrite dans une périphérie de la région d'irradiation (IR) comme étant une position de départ (S1) d'un cycle initial du premier balayage dans la région d'irradiation (IR), et
l'unité d'alignement de position d'irradiation (63) définit la position d'irradiation à une extrémité sur un côté plus proche de la position de départ (S1) afin qu'elle ne soit pas inscrite dans la périphérie de la région d'irradiation (IR) dans au moins l'un quelconque du deuxième cycle du premier balayage ou du balayage ultérieur dans la région d'irradiation (IR).

2. Une méthode de recuit laser pour irradier une région d'irradiation (IR) ayant une forme circulaire sur une pièce à usiner avec un faisceau laser pour un processus de recuit, la méthode comprenant le fait de :
irradier séquentiellement différentes positions d'irradiation dans la région d'irradiation (IR) avec le faisceau laser en balayant le faisceau laser; et
ajuster la position d'irradiation dans le balayage de sorte que les différentes positions d'irradiation dans la région d'irradiation (IR) sont alignées le long de chacune d'une première direction et d'une deuxième direction qui se croisent mutuellement, dans laquelle
le balayage comprend un premier balayage consistant à balayer le faisceau laser le long de la première direction et un deuxième balayage consistant à balayer le faisceau laser le long de la deuxième direction,
la position d'irradiation dans au moins l'un quelconque du premier balayage ou du deuxième balayage est ajustée de sorte que les différentes positions d'irradiation dans la région d'irradiation (IR) sont alignées le long de chacune de la première direction et de la deuxième direction,
le premier balayage est exécuté de sorte que le faisceau laser est balayé linéairement entre les deux extrémités de la région d'irradiation (IR) le long de la première direction, et le deuxième balayage est exécuté de sorte que le faisceau laser est balayé le long de la deuxième direction pour décaler une position du premier balayage subséquent,
la position d'irradiation est ajustée de sorte que chaque position d'irradiation dans le premier balayage ultérieur parmi deux cycles continus du premier balayage, où le deuxième balayage est intercalé entre les deux cycles du premier balayage, est alignée avec chaque position d'irradiation dans le premier balayage antérieur le long de la deuxième direction,
**caractérisé en ce que**
la méthode comprend en outre le fait de définir la position d'irradiation inscrite dans une périphérie de la région d'irradiation (IR) comme étant une position de départ (S1) d'un cycle initial du premier balayage dans la région d'irradiation (IR), et
la position d'irradiation à une extrémité sur un côté plus proche de la position de départ (S1) est définie afin qu'elle ne soit pas inscrite dans la périphérie de la région d'irradiation (IR) dans au moins l'un quelconque du deuxième cycle du premier balayage ou du balayage ultérieur dans la région d'irradiation (IR).

3. Un support de stockage stockant un programme de recuit laser pour irradier une région d'irradiation (IR) ayant une forme circulaire sur une pièce à usiner avec un faisceau laser pour un processus de recuit, le programme de recuit laser amenant un ordinateur à exécuter les étapes comprenant le fait de :
irradier séquentiellement différentes positions d'irradiation dans la région d'irradiation (IR) avec le faisceau laser en balayant le faisceau laser ; et
ajuster la position d'irradiation dans le balayage de sorte que les différentes positions d'irradiation dans la région d'irradiation (IR) sont alignées le long de chacune d'une première direction et d'une deuxième direction qui se croisent mutuellement, dans lequel
le balayage comprend un premier balayage consistant à balayer le faisceau laser le long de la première direction et un deuxième balayage consistant à balayer le faisceau laser le long de la deuxième direction,
la position d'irradiation dans au moins l'un quelconque du premier balayage ou du deuxième balayage est ajustée de sorte que les différentes positions d'irradiation dans la région d'irradiation (IR) sont alignées le long de chacune de la première direction et de la deuxième direction,
le premier balayage est exécuté de sorte que le faisceau laser est balayé linéairement entre les deux extrémités de la région d'irradiation (IR) le long de la première direction, et le deuxième balayage est exécuté de sorte que le faisceau laser est balayé le long de la deuxième direction pour décaler une position du premier balayage subséquent,
la position d'irradiation est ajustée de sorte que chaque position d'irradiation dans le premier balayage ultérieur parmi deux cycles continus du premier balayage, où le deuxième balayage est intercalé entre les deux cycles du premier balayage, est alignée avec chaque position d'irradiation dans le premier balayage antérieur le long de la deuxième direction,
**caractérisé en ce que**
le programme de recuit laser amène en outre l'ordinateur à exécuter une étape comprenant le fait de définir la position d'irradiation inscrite dans une périphérie de la région d'irradiation (IR) comme étant une position de départ (S1) d'un cycle initial du premier balayage dans la région d'irradiation (IR), et
la position d'irradiation à une extrémité sur un côté plus proche de la position de départ (S1) est définie afin qu'elle ne soit pas inscrite dans la périphérie de la région d'irradiation (IR) dans au moins l'un quelconque du deuxième cycle du premier balayage ou du balayage ultérieur dans la région d'irradiation (IR).
